(19) **Europäisches Patentamt / European Patent Office / Office européen des brevets**

(11) **EP 2 130 217 B1**

(12) **EUROPEAN PATENT SPECIFICATION**

(45) Date of publication and mention
of the grant of the patent:
**26.09.2012 Bulletin 2012/39**

(51) Int Cl.:
***H01L 21/762*** (2006.01)

(21) Application number: **08719378.5**

(22) Date of filing: **14.03.2008**

(86) International application number:
**PCT/IB2008/000736**

(87) International publication number:
**WO 2008/120074 (09.10.2008 Gazette 2008/41)**

(54) **IMPROVING THE QUALITY OF A THIN LAYER THROUGH HIGH-TEMPERATURE THERMAL ANNEALING**

ERHÖHUNG DER QUALITÄT EINER DÜNNSCHICHT DURCH HOCHTEMPERATURGLÜHUNG

AMÉLIORATION DE LA QUALITÉ D'UNE COUCHE MINCE PAR UN RECUIT THERMIQUE HAUTE TEMPÉRATURE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **29.03.2007 FR 0754131**

(43) Date of publication of application:
**09.12.2009 Bulletin 2009/50**

(73) Proprietor: **Soitec**
**38190 Bernin (FR)**

(72) Inventors:
• **BOURDELLE, Konstantin**
**F-38920 CROLLES (FR)**
• **NGUYEN, Nguyet Phuong**
**F-38100 Grenoble (FR)**
• **SCHWARZENBACH, Walter**
**F-38330 Saint Nazaire les Eymes (FR)**

(74) Representative: **Grünecker, Kinkeldey, Stockmair & Schwanhäusser**
**Leopoldstrasse 4**
**80802 München (DE)**

(56) References cited:
**EP-A- 1 359 615      EP-A- 1 628 339**
**FR-A1- 2 858 462     US-A1- 2004 262 686**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## CONTEXT

The present invention relates to the production of composite structures. More precisely, the invention proposes a method of forming a structure comprising a layer in a semiconductor material taken from a donor substrate, the method comprising the following successive steps:

(a) implantation of atomic species to form an embrittlement zone in the donor substrate at a given depth;
(b) assembly of the donor substrate to a receiver substrate;
(c) supply of energy to detach the layer taken from the donor substrate at the embrittlement zone;
(d) finishing treatment for the layer removed to improve its surface condition.

The types of methods mentioned above are already known to the person skilled in the art. Smart Cut™ type methods are one example that corresponds to a preferred embodiment of the invention.

Such methods allow structures comprising a thin layer in a semiconductor material to be produced.

In order to obtain specifics on the abovementioned technology, the person skilled in the art may, for example, refer to:

- J.-P. COLINGE, "Silicon-on-Insulator technology: materials to VLSI, second edition," p. 50-51, Kluwer Academic Publishers, 1991.

EP -A1- 1 628 339 discloses a method of transferring a layer from a first wafer to a second wafer including a pre-anneal step at a first temperature $T_1$ in the range 200°C - 400°C (see paragraphs 72 and 73) and an annealing heat treatment step at a higher temperature $T_2$ of about 500°C.

EP -A1- 1 359 615 discloses a method for the separation of two layers of material along a weakening layer by thermal annealing with four different phases. The thermal annealing starts with a temperature plateau at roughly 350°C followed by a slow ramp up of the temperature at 10°C per minute. When the temperature reaches a transition temperature of the order of 430°C to 450°C, corresponding to the onset of exfoliation, a second ramp up of the temperature at a significantly higher speed of 16°C per minute starts. This ramp up continues until a temperature of the order of 600°C - 800°C is reached. At the maximum, the temperature remains constant for an extended period of time.

US 2004/262686 discloses a layer transfer technique in which the bonded wafers are annealed at one or two annealing temperatures. The annealing temperatures are of the order of 500°C or higher.

FR -A1- 2 858 462 discloses a method for exfoliating a thin layer from a donor substrate after co-implantation of at least two different atomic species to form a weakening zone. The method further includes a rapid thermal annealing step for a duration of 1-60 seconds and with a temperature between 900°C and 1300°C.

Structures obtained by such methods are implemented for applications in the fields of microelectronics, optics and/or optoelectronics.

These structures are of the Silicon On Insulator (SOI) type, in the case where the layer taken is in silicon or of the strained SOI (sSOI) type in the case where the layer taken is in strained silicon. Other types of composite structures may also be obtained.

Step (a) consists of implanting one or more ionized species in the donor substrate which subsequently will form a zone of defects that are more or less buried, depending on the implantation energy. These defects will be able to develop and will lead to detachment of the layer taken in step (c).

The energy utilized in step (c) is at least partly supplied in thermal form by detachment annealing. Consequently, the heat budget (that is, in a first approach, the temperature / thermal treatment duration pair) must be considered to determine the moment when the layer to be removed will be detached.

Beyond the heat budget, temperature distribution (between the top and the bottom of the oven) is also important.

After the detachment performed in step (c), roughness, imperfections in the removed layer and/or reduction in the crystalline quality of the surface may generally be observed.

Given the specified applications, specifications for the surface condition of the structures utilized are generally very strict: the roughness of the thin layer is a parameter that to a certain extent determines the quality of the components that will be made on the structure.

To treat these surface defects, a finishing treatment may be implemented with the object of conforming to the final roughness requirements that the free face of the substrate must meet for its subsequent use.

These finishing steps correspond to additional steps of the method which tend to make the method more complex and more costly.

A known method to reduce surface defects such as those mentioned above consists of carrying out detachment annealing (step c) at a " high temperature "(which usually corresponds to a temperature of over 500 °C in the present text).

Documents US 2003/0216008 and WO 2005/086228 provide examples of such detachment annealings, particularly by exposing the wafers to a "high temperature" for a given duration in order to initiate detachment.

These documents demonstrate that roughness is reduced when detachment annealing is performed in part at a "high temperature," which consequently allows the finishing step to be simplified.

In fact, it is thought that the act of prolonging detachment annealing at a "high temperature" allows certain surface defects issued from the detachment to be "healed."

However, the act of carrying out detachment annealing at such temperatures produces an undesirable effect: it is sometimes difficult to detach the donor substrate from the structure produced.

This is generally explained by a reattachment phenomenon of the donor substrate and of the structure produced at the detachment interface when the assembly is subjected to a "high temperature."

## SUMMARY OF THE INVENTION

The present invention proposes to mitigate the abovementioned problems and particularly to enable the implementation of "high temperature" detachment annealing by reducing the risk of reattachment. For this purpose, the invention proposes a method for forming a structure comprising a layer in a semiconductor material taken from a donor substrate, the method comprising the following successive steps, (a) implantation of atomic species to form a zone of embrittlement in the donor substrate at a given depth ; (b) assembly of the donor substrate to a receiver substrate; (c) supply of energy to detach the layer taken from the donor substrate at the embrittlement zone by implementing detachment annealing carried out at a high temperature; (d) finishing treatment of the layer taken in view of improving its surface condition, characterized in that in detachment step (c), the high-temperature detachment annealing develops according to an upgrade, i.e. a rising ramp, allowing a high temperature to be reached, said high temperature corresponding to the maximum detachment annealing temperature and in that the duration of exposure to said high temperature is limited in such a way as to prevent the appearance of significant defectivity at the surface of the structure obtained after detachment.

Preferred, but not limiting, aspects of this method are the following

- the duration (D) of exposure to said high temperature is less than or equal to a limit that is a linear function (L) of the high temperature,
- the linear function is of the form: D = -3/5 HT + 450, where HT and D are, respectively, the high temperature expressed in degrees Celsius and the duration of exposure to said high temperature expressed in minutes,
- the duration (D) of exposure to said high temperature is equal to said limit (L),
- the duration of exposure to said high temperature is null in such a way that said upgrade is immediately followed by a downgrade, i. e. a descending ramp, during which the temperature decreases,
- in the upgrade, the temperature increases 10°C per minute,

- in the downgrade, the temperature decreases 10 °C per minute,
- the maximum value the high temperature reaches during the upgrade is greater than 500 °C,
- the maximum value the high temperature reaches during the upgrade is greater than 600 °C,
- the maximum temperature reached during the upgrade is between 700°C and 750°C,
- the implantation phase (a) is a co-implantation step, preferably hydrogen and helium species are implanted, typically by implanting the hydrogen first,

In addition, the invention relates to a silicon on insulator type structure obtained after having carried out steps (a) (b) and (c) of the method of the invention, this structure presenting a roughness measured after detachment of 10 Angstroms RMS for 10x10 $\mu m^2$ surfaces.

## PRESENTATION OF FIGURES

Other characteristics and advantages of the invention will further emerge from the following description, which is purely illustrative and non-limiting and must be read with regard to the attached figures in which:

- Figure 1 represents the heat budget implemented during detachment annealing in conformance with the present invention,
- Figure 2 represents the heat budget implemented during detachment annealing such as is known in the prior art,
- Figure 3 represents the average roughness (expressed in DWN Haze) of SOI structures after detachment according to the maximum temperature reached during detachment annealing, for durations of exposure to the maximum temperature equal to 0, 10, and 30 minutes respectively,
- Figures 4a, 4b and 4c represent maps of defects observed after detachment on SOI structures obtained by implementing a known type of detachment annealing in which exposure to the " high temperature "is of a duration equal to 30 minutes, the " high temperature "being equal to 500°C (4a), 600°C (4b) and 675°C (4c),
- Figure 5 represents a map of defects observed after detachment on an SOI structure obtained by implementing detachment annealing according to the invention presenting a temperature "peak" equal to 675°C,
- Figure 6 is a table illustrating the results obtained in terms of ease of detachment in structures having undergone detachment annealings in which the value of the " high temperature "and the duration of exposure are variable,
- Figure 7 represents the average roughness (expressed in DWN Haze) of an SOI structure after detachment according to the maximum temperature reached during detachment annealing, each of these structures having been obtained by a different type of implantation: Hydrogen+Helium, Helium+Hydrogen, Hydrogen alone,

- Figure 8 represents the average local roughness RMS measured on 10x10 $\mu m^2$ surfaces according to the maximum temperature reached during detachment annealing, each of these structures having been obtained by a different type of implantation: Hydrogen+Helium, Helium+Hydrogen or Hydrogen alone,
- Figure 9 is a table grouping together the "feasibility" of detachment by carrying out detachment annealing according to the invention for different implantation conditions and for several "high temperature" values.

## DESCRIPTION OF THE INVENTION

As has already been mentioned, the invention relates to the production of structures comprising a layer in a semiconductor material taken from a donor substrate according to general steps (a) to (c) or (d) mentioned in the introduction to this text.

The layer in a semiconductor material is obtained by detachment at the donor substrate that has been embrittled by the implantation of species.

In particular, the invention may improve the quality of the structure obtained by implementing the Smart Cut™ type method, particularly by reducing the roughness and defectivity of the structure obtained after detachment annealing, before possible finishing steps.

The invention also enables these finishing steps to be minimized and therefore the duration of the method to be reduced.

In the context of the method according to the invention, different conditions of implantation in a donor substrate (step (a)) and of detachment annealing (step (c)) were evaluated to obtain SOI type structures.

Implantation step (a) has therefore been implemented according to three variations, noted H, H+He and He+H:

- H: implantation in hydrogen alone (conditions that will be discussed in the present text correspond to a concentration equal to $1.0x10^{16}$ cm$^{-2}$ and an implantation energy equal to 32 keV) ;
- He+H: sequential co-implantation of helium then hydrogen (conditions that will be discussed in the present text correspond to a concentration equal to $1.0x10^{16}$ cm$^{-2}$ for each of the two species and implantation energies equal to 32 keV for hydrogen and 52 keV for helium);
- H+He: sequential co-implantation of hydrogen then helium (conditions that will be discussed in the present text correspond to a concentration equal to $1.0x10^{16}$ cm$^{-2}$ for each of the two species and implantation energies equal to 32 keV for hydrogen and 52 keV for helium).

In an advantageous variation, the invention will thus proceed to a co-implantation step. Generally, step (a) will be designated as an implantation step, as one or more species are implanted.

It is specified that co-implantation reduces the dose of species implanted.

After the implantation step, the assembly step (b) is implemented by putting the donor substrate in contact with the receiver substrate.

These assembled substrates then undergo detachment annealing according to a change in the given temperature.

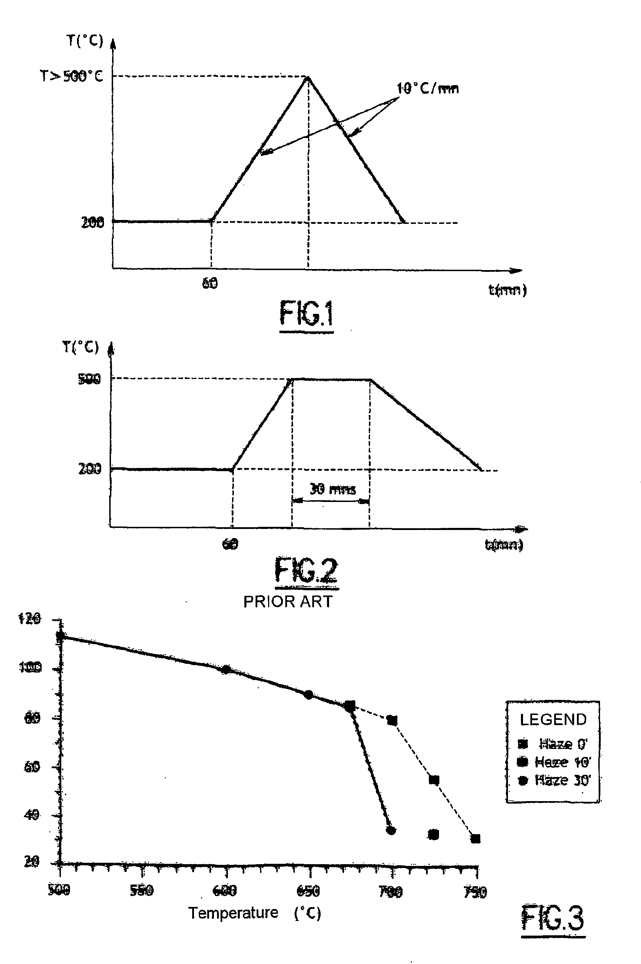

As illustrated in Figure 1, detachment annealing generally starts by a temperature range equal to 200°C for approximately one hour, which contributes to reinforcing the bonding interface.

The temperature then increases according to an upgrade during which the temperature increases (at a speed that may be 10°C per minute) up to a " high temperature "greater than or equal to 500°C.

As soon as the high temperature is reached, the temperature is decreased immediately (at a speed that may be 10°C per minute) until a temperature on the order of 200°C is reached; therefore, exposure to a " high temperature "is limited.

Figure 2 illustrates a known type of detachment annealing in which the " high temperature "is stabilized in a range (which may have a duration on the order of 30 minutes, for example).

In order to characterize the quality of the SOI structures following detachment annealing, the structures are subjected to several tests: "roughness test," "defectivity test."

These two types of tests indicate two distinct qualities of the structures.

The roughness is that of the surface of the transferred layer, after detachment. Known "high temperature" detachment annealings seek to reduce this roughness.

As for defectivity, this corresponds to - in all cases in the sense of the present text - defects with substantially bigger sizes than the representative roughness quantities. These defects correspond to partial tearings of the transferred layer. The defectivity therefore indicates possible reattachments of the layer before its transfer. In this text, the term "defect" corresponds to this defectivity and it therefore does not cover roughness, in particular.

The DWN haze measurement describes the average roughness measured on the entire surface of the structure obtained. This haze is measured by SP1 scanning the surface to be analyzed. Its principle is based on the detection of the luminous intensity diffused by the wafer in response to a laser beam with a wavelength equal to 488 nm. The luminous intensity diffused is recovered by two channels of different sizes: a "narrow"' channel (this is DNN haze) or a "large" channel (this is DWN haze).

Figure 3 represents the DWN haze of SOI structures after detachment according to the maximum temperature reached during detachment annealing, for durations of exposure at the maximum temperature equal to 0 (that is, detachment annealing according to the invention), 10, and 30 minutes.

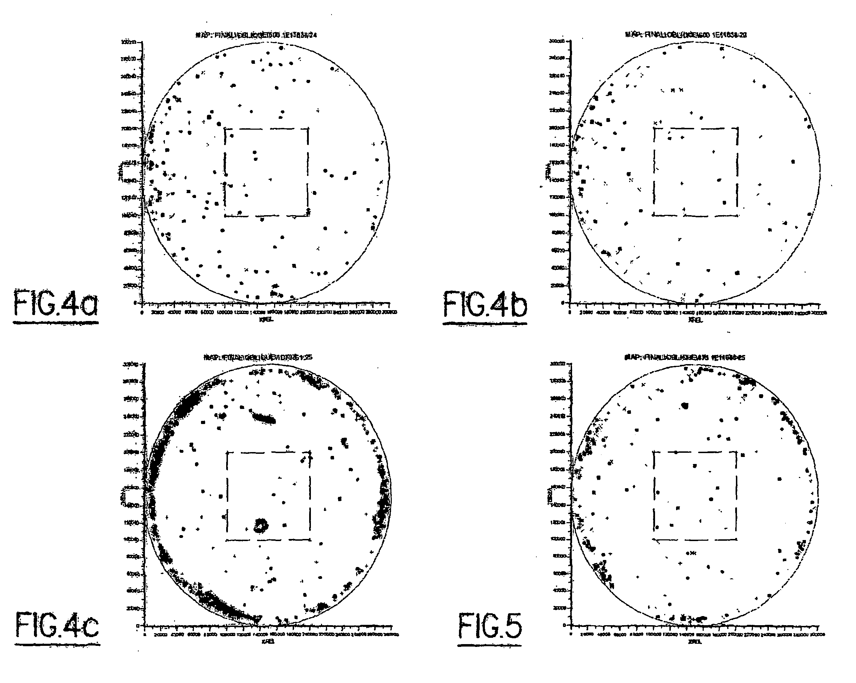

Figures 4a, 4b and 4c represent defect maps observed by SP1 after detachment on SOI structures for maximum detachment annealing temperatures, respectively equal to 500°C, 600°C and 675°C. Exposure at this " high temperature "is for 30 minutes (known type of detachment annealing).

In Figures 3, 4a, 4b and 4c, the implantation conditions are those mentioned previously.

Figure 3 clearly indicates, as known and mentioned previously, that the act of increasing the detachment annealing temperature improves roughness. In fact, as illustrated in Figure 3, the average roughness improves (is reduced) when the maximum detachment annealing temperature increases, regardless of the duration of exposure.

In addition, Figure 3 indicates that the act of reducing the exposure duration at a high temperature allows detachment annealing to be carried out at higher temperatures in good conditions.

More precisely, it has been observed in the structures whose qualities are illustrated in Figure 3 that it was in practice difficult, or even impossible, to correctly detach the layer to be transferred for detachment temperatures greater than 700°C (in the case of a 30 minute range at this detachment temperature) and greater than 750°C (in the case of a 10 minute range).

This is comparable to the results illustrated in Figures 4a, 4b and 4c.

In fact, it is noted in these figures that the act of raising the "high temperature" leads to increased tearings on the edges of the transferred layer of the structure obtained; it was difficult to detach the substrates.

In addition, a phenomenon of reattachment due to the Silicon-Silicon bonds is noted at these high temperatures.

In Figure 4c, numerous tearings are thus visible on the edges of the wafer.

This tearing phenomenon is reduced when detachment annealing in conformance with the invention is put in place as is seen in Figure 5 where, in comparison with Figure 4c (which corresponds to the same "high temperature "value), defects on the edges have markedly decreased.

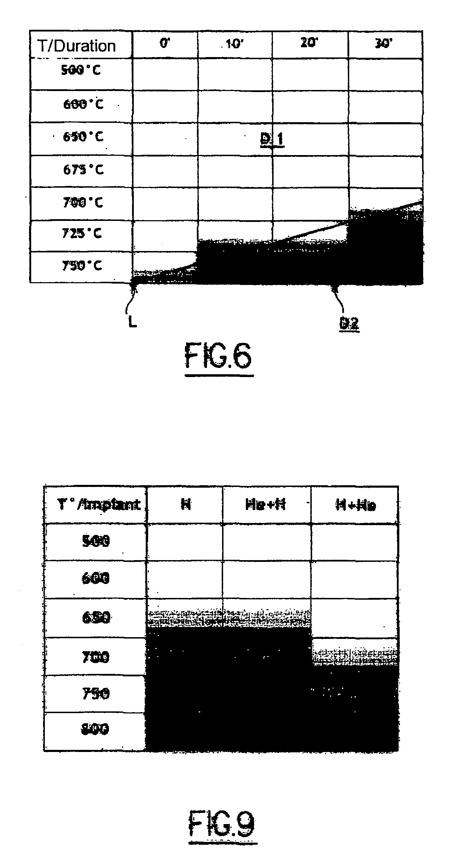

The table from Figure 6 illustrates, in an overall manner, the advantage that reducing the duration of exposure at a "high temperature" presents.

In fact, above we saw that the act of increasing the high temperature improves roughness after detachment but that this is likely to lead to reattachment of the substrates.

The table in Figure 6 illustrates the results in terms of the defectivity obtained after various detachment annealing conditions ("high temperature" value, duration of exposure at this "high temperature").

In this table, when the boxes are white, this means that the detachment is done correctly and when there is color shading (white + grey or black + grey), it becomes more and more difficult but not impossible to separate the substrates, on the contrary, when they are black the substrates are highly impaired or even broken, which results in excessive reattachment.

For example, for an exposure duration of 30 minutes at a " high temperature "greater than 750°C, it was not possible to detach the substrates, while this was possible for a lower exposure duration at the same " high temperature. "

The table from Figure 6 identifies a limit L that delimits the limiting conditions (the value of the highest temperature during detachment annealing - that will be designated HT; the duration of exposure to this highest temperature - that will be designated D) allowing a structure with good quality in terms of defectivity to be obtained. This limit L separates two fields D1 and D2.

Field D1 corresponds to acceptable conditions. Field D2 corresponds to conditions that lead to a defectivity that is too significant.

According to the invention, detachment annealing is carried out in field D1; that is, the "highest temperature" value and exposure duration that is lower than the limit values are maintained.

It is observed that limit L corresponds to conditions in which duration D is a substantially linear function of the highest temperature HT.

More precisely, limit L may be characterized as corresponding to the equation:

$$D = -3/5 \ HT + 450.$$

Thanks to the demonstration of this limit, it is possible to optimize the exposure at high temperatures by choosing a duration D and a temperature HT that corresponds to a point of the limit L.

In a variation of embodiment of the invention, exposure to the maximum "high temperature" reached during detachment annealing is instantaneous and the temperature is caused to decrease as soon as this maximum value has been reached. This particularly corresponds to the example of Figure 1.

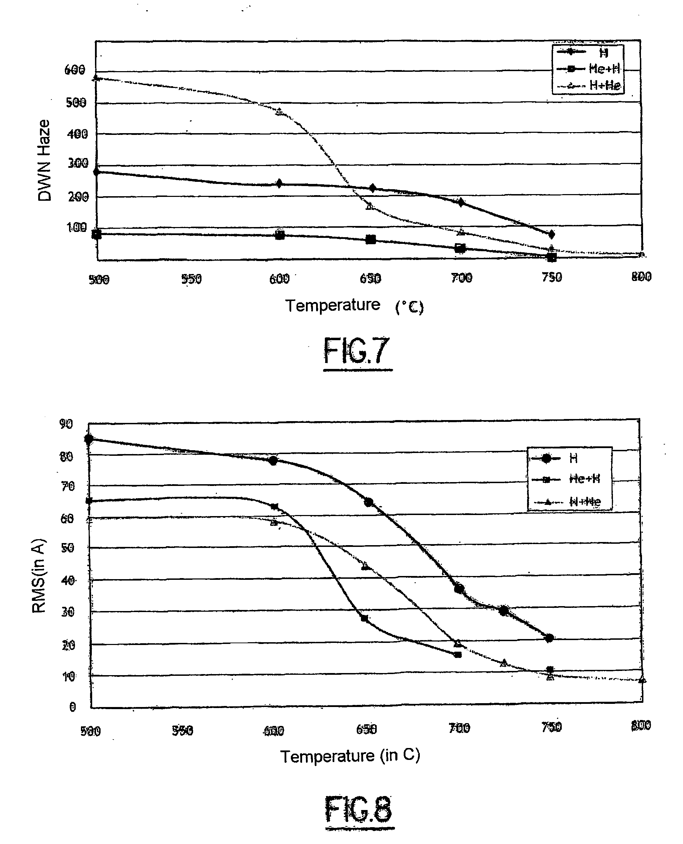

Figures 7 and 8 illustrate the roughnesses obtained at the end of detachment annealing on SOI structures for different maximum temperature values of the detachment annealing and for different variations of implantation.

In these figures, it is specified that:

- When the maximum detachment annealing temperature is equal to 500°C, the annealing utilized is of the known type, with a range at 500°C for 30 minutes (see Figure 2),

- when the maximum detachment annealing temperature is greater than 500°C, the annealing presents a temperature "peak" greater than 500°C and immediately falls again, in conformance with a variation of the invention (see Figure 1).

In Figure 7, the DWN haze is represented as a function of the maximum detachment annealing temperature (between 500°C and 800°C), measured on an SOI structure for the three types of implantation variations.

The general evolution of the DWN haze is found, which diminishes for the highest maximum temperatures. This reduction, which corresponds to an improved surface condition, is particularly significant for a maximum temperature greater than 600°C.

It is also remarked that the most important gain is observed for the H+He variation. In fact, for a temperature of less than 650°C, the DWN haze is very high, but from 650°C, it diminishes and rapidly catches up with the DWN haze from the He+H variation.

The observations performed in SP1, and illustrated in Figure 7, are to be correlated with the roughness measurements taken by an atomic force microscope (AFM). This allows the roughness characterized by a root mean square (RMS) of the size of defects to be determined by scanning a part of the surface measured over $2x2\ \mu m^2$ to $40x40\ \mu m^2$ surfaces by using the microscope, this RMS roughness is expressed in Angstroms (A).

The RMS roughness measured over $10x10\ \mu m^2$ surfaces of SOI structures according to the maximum temperature of the detachment annealing heat budget is thus represented in Figure 8.

The RMS roughness decreases according to the detachment annealing temperature. It is to be remarked that the two co-implantation variations present roughnesses of less than those from the H variation.

In addition, for the three variations, it has been observed that it is particularly advantageous to bring the detachment annealing to temperatures greater than 600°C.

From 750 °C, the two co-implantation variations allow surfaces with equivalent roughnesses to be obtained.

In all cases, detachment annealing is brought to a "high temperature" by minimizing the duration of exposure to high temperatures (in particular, to heal or, in any case, reduce the surface defects issued from the detachment).

For the three variations of implantations tested, the table from Figure 9 illustrates (on the same principle as the table from Figure 6), the feasibility of detaching the substrates after detachment annealing according to the invention in the variation where the temperature decreases as soon as the maximum temperature is reached during detachment.

This table indicates that the H+He implantation produces the best results in terms of defectivity. This identifies this type of implantation as the most advantageous while it may be considered equivalent to an He+H implantation under roughness alone.

Thanks to these results, it is possible to evaluate the limit temperature regarding the choice of the temperature peak value of the detachment annealing according to the invention, in fact for the three implantation variations, it was not possible to detach the wafers beyond 800°C.

The invention also allows:

- the benefit of an improved surface condition after detachment, thanks to exposure to a high temperature,
- while delaying the appearance of disadvantages due to reattachment, thanks to limiting the duration of exposure to a "high temperature."

Therefore, the results shown in the present description show that the heat budget of the invention allows the surface condition of the structure obtained to be improved when the temperature is greater than 500°C, and more particularly greater than 600°C and less than or equal to 750°C.

It is also to be noted that these particularly advantageous results are obtained by utilizing a variation of co-implantation during step (a). And, H+He co-implantation produces particularly advantageous results in terms of defectivity.

In addition, elimination of the range allows the duration of Smart Cut™ type methods to be reduced, as the detachment annealing duration is reduced.

SOI type structures obtained after detachment annealing according to the invention present a roughness that is less than the roughnesses obtained according to the known type of detachment annealing (with high temperature range). This roughness is typically from 70 to 100 A RMS for implantation of Hydrogen alone and for a maximum detachment annealing temperature of 500°C.

The example described focuses on SOI structures; of course the person skilled in the art may easily transpose the present invention to other types of structures that may be obtained via Smart Cut™ type methods.

In particular, results comparable to those described in the present description have been obtained for sSOI structures in which the implantation and fracture are carried out in relaxed SiGe. More generally, the invention is applicable to any structure obtained by layer transfer according to steps (a) to (c) or (d) referred to in this text.

**Claims**

1.　A method of forming a structure comprising a layer in a semiconductor material taken from a donor substrate, the method comprising the following steps:

(a) implantation of atomic species to form an embrittlement zone in the donor substrate at a given depth;

(b) assembly of the donor substrate to a receiver substrate;

(c) supplying energy to detach the layer taken from the donor substrate at the embrittlement zone by implementing detachment annealing carried out at a high temperature;

(d) finishing treatment of the layer taken in view of improving its surface condition, **characterized in that** in detachment step (c), the high temperature detachment annealing evolves according to a temperature upgrade allowing a high temperature to be reached,

wherein said high temperature corresponds to the maximum detachment annealing temperature and is greater than 600°C and the duration (D) of exposure to said high temperature is less than or equal to a limit that is given by the following linear function (L) of the high temperature:

$$D = -3/5 \; HT + 450,$$

where HT and D are, respectively, the high temperature expressed in degrees Celsius and the duration of exposure to said high temperature expressed in minutes.

2. The method according to claim 1, **characterized in that** the duration (D) of exposure to said high temperature is equal to said limit (L).

3. The method according to one of the previous claims, **characterized in that** the duration of exposure to said high temperature is null in such a way that said temperature upgrade is immediately followed by a temperature downgrade during which the temperature decreases.

4. The method according to one of the previous claims, **characterized in that** in the temperature upgrade the temperature increases 10°C per minute.

5. The method according to one of the previous claims, **characterized in that** the temperature in the temperature downgrade decreases 10°C per minute.

6. The method according to the previous claim, **characterized in that** the maximum temperature reached during the temperature upgrade is between 700°C and 750°C.

7. The method according to one of the previous claims, **characterized in that** the implantation phase (a) is a co-implantation step.

8. The method according to the previous claim, **characterized in that** the hydrogen and helium species are implanted.

9. The method according to the previous claim, **characterized in that** the hydrogen is implanted first.

## Patentansprüche

1. Verfahren zum Bilden einer Struktur mit einer Schicht in einem Halbleitermaterial von einem Donor-Substrat, wobei das Verfahren die folgenden Schritte umfasst:

(A) Implantieren von atomaren Spezies, um eine Versprödungszone in dem Donor-Substrat in einer bestimmten Tiefe zu bilden;

(B) Zusammenfügen des Donor-Substrates mit einem Empfänger-Substrat;

(C) Zuführen von Energie zum Ablösen der Schicht von dem Donor-Substrat an der Versprödungszone mittels Ablösen durch Glühen, welches bei einer hohen Temperatur durchgeführt wird;

(D) Nachbehandlung der Schicht im Hinblick auf die Verbesserung ihrer Oberflächenbeschaffenheit, **dadurch gekennzeichnet, dass** sich das Ablösen durch Hochtemperaturglühen im Ablöseschritt (c) gemäß einer Temperaturerhöhung entwickelt, welche es ermöglicht, eine hohe Temperatur zu erreichen,

wobei die hohe Temperatur der maximalen Glühtemperatur des Ablösens entspricht und höher als 600°C ist, und die Dauer (D) des Einwirkens der hohen Temperatur geringer oder gleich einem Grenzwert ist, der durch die folgende lineare Funktion (L) der hohen Temperatur gegeben ist:

$$D = -3/5 \; HT + 450,$$

wobei HT bzw. D die hohe Temperatur, angegeben in Grad Celsius, bzw. die Dauer des Einwirkens der hohen Temperatur in Minuten ist.

2. Das Verfahren nach Anspruch 1, **dadurch gekennzeichnet, dass** die Dauer (D) des Einwirkens der hohen Temperatur gleich dem Grenzwert (L) ist.

3. Das Verfahren nach einem der vorhergehenden Ansprüche, **dadurch gekennzeichnet, dass** die Dauer des Einwirkens der hohen Temperatur Null ist, dergestalt, dass auf die Temperaturerhöhung sofort eine Absenkung der Temperatur folgt, während derer die Temperatur abnimmt.

4. Das Verfahren nach einem der vorhergehenden Ansprüche, **dadurch gekennzeichnet, dass** die Temperatur während der Temperaturerhöhung um 10°C pro Minute zunimmt.

5. Das Verfahren nach einem der vorhergehenden Ansprüche, **dadurch gekennzeichnet, dass** die Temperatur während der Absenkung der Temperatur um 10°C pro Minute abnimmt.

6. Das Verfahren nach dem vorhergehenden Anspruch, **dadurch gekennzeichnet, dass** die maximale Temperatur, die während der Temperaturerhöhung erreicht wird, zwischen 700°C und 750°C liegt.

7. Das Verfahren nach einem der vorhergehenden Ansprüche, **dadurch gekennzeichnet, dass** die Implantationsphase (a) ein Co-Implantationsschritt ist.

8. Das Verfahren nach dem vorhergehenden Anspruch, **dadurch gekennzeichnet, dass** die Spezies Wasserstoff und Helium implantiert werden.

9. Das Verfahren nach dem vorhergehenden Anspruch, **dadurch gekennzeichnet, dass** der Wasserstoff zuerst implantiert wird.

**Revendications**

1. Procédé de formation d'une structure comprenant une couche en matériau semi-conducteur prélevée à partir d'un substrat donneur, le procédé comprenant les étapes suivantes:

> (a) implantation d'espèces atomiques pour former une zone de fragilisation dans le substrat donneur à une profondeur déterminée;
> (b) assemblage du substrat donneur à un substrat receveur;
> (c) apport d'énergie pour détacher la couche prélevée du substrat donneur au niveau de la zone de fragilisation en mettant en oeuvre un recuit de détachement mené à haute température;
> (d) traitement de finition de la couche prélevée en vue d'améliorer son état de surface, **caractérisé en ce que** dans l'étape (c) de détachement, le recuit de détachement haute température évolue selon une rampe montante permettant d'atteindre une haute température, ladite haute température correspondant à la température maximale du recuit de détachement et étant supérieure à 600°C et **en ce que** la durée (D) d'exposition à ladite haute température est inférieure ou égale à une limite qui est donnée par la fonction linéaire (L) suivante de la haute température:

$$D = -3/5 \; HT + 450,$$

où HT et D sont respectivement, la haute température exprimée en degrés Celsius et la durée d'exposition à ladite haute température exprimée en minutes.

2. Procédé selon la revendication 1, **caractérisé en ce que** la durée (D) d'exposition à ladite haute température est égale à ladite limite (L).

3. Procédé selon l'une des revendications précédentes, **caractérisé en ce que** la durée d'exposition à ladite haute température est nulle de sorte que ladite rampe montante de la température est immédiatement suivie d'une rampe descendante de la température lors de laquelle la température décroît.

4. Procédé selon l'une des revendications précédentes, **caractérisé en ce que** dans la rampe montante la température croit de 10°C par minute.

5. Procédé selon l'une des revendications précédentes, **caractérisé en ce que** dans la rampe descendante la température décroît de 10°C par minute.

6. Procédé selon la revendication précédente, **caractérisé en ce que** la température maximale atteinte lors de la rampe montante est comprise entre 700°C et 750°C.

7. Procédé selon l'une des revendications précédentes, **caractérisé en ce que** la phase d'implantation (a) est une étape de co-implantation.

8. Procédé selon la revendication précédente, **caractérisé en ce que** les espèces d'hydrogène et d'hélium sont implantées.

9. Procédé selon la revendication précédente, **caractérisé en ce que** l'hydrogène est d'abord implanté.

FIG.1

FIG.2

PRIOR ART

Temperature (°C)

FIG.3

LEGEND
■ Haze 0'
● Haze 10'
● Haze 30'

FIG.4b

FIG.5

FIG.4a

FIG.4c

| T/Duration | 0' | 10' | 20' | 30' |
|------------|-----|-----|-----|-----|
| 500°C | | | | |
| 600°C | | | | |
| 650°C | | | D.1 | |
| 675°C | | | | |
| 700°C | | | | |
| 725°C | | | | |
| 750°C | | | | |

L          D.2

## FIG.6

| T°/Implant | H | He+H | H+He |
|------------|-----|------|------|
| 500 | | | |
| 600 | | | |
| 650 | | | |
| 700 | | | |
| 750 | | | |
| 800 | | | |

## FIG.9

FIG.7

FIG.8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1628339 A1
- EP 1359615 A1
- US 2004262686 A
- FR 2858462 A1
- US 20030216008 A
- WO 2005086228 A

### Non-patent literature cited in the description

- **J.-P. COLINGE.** Silicon-on-Insulator technology: materials to VLSI. Kluwer Academic Publishers, 1991, 50-51